# EUROPÄISCHE PATENTSCHRIFT

(11) **EP 0 275 877 B1**
(45) Veröffentlichungstag und Bekanntmachung des Hinweises auf die Patenterteilung: **26.10.1994**
(21) Anmeldenummer: 88100121.8
(22) Anmeldetag: 07.01.1988
(51) Int. Cl.: B23K 20/00, B23K 20/10, H01L 21/607

(54) **Überwachung von Bondparametern während des Bondvorganges**
Bond paramaters control during bonding
Contrôle des paramètres de jonction pendant la fixation des fils de connexion

(30) Priorität: 21.01.1987 DE 3701652
(43) Veröffentlichungstag der Anmeldung: 27.07.1988
(73) Patentinhaber: SIEMENS AKTIENGESELLSCHAFT, 80333 München (DE)
(72) Erfinder: v. Raben, Klaus-Ulrich, Ph. D., D-8000 München 71 (DE)

(56) Entgegenhaltungen:
- DE-A- 3 233 629
- DE-A- 3 435 511
- US-A- 3 827 619
- US-A- 3 857 279
- US-A- 4 040 885
- PROCEEDINGS OF THE ELECTRONIC COMPONENTS CONFERENCE 9-11 May 1988 Los Angeles,California Seiten 558 - 561; K.Ulrich von Raben: "Controlling relevant bonding parameters of modern bonders"

## Beschreibung

Die Erfindung betrifft eine Vorrichtung zur kontinuierlichen Überwachung der Bondkraft und der Ultraschallamplitude bei halb- und vollautomatischen, einen Ultraschallgenerator und einen Bondarm aufweisenden Bondmaschinen, bei welcher die verstärkten Ausgangssignale eines ersten Sensors zur Messung der Bondkraft und eines zweiten Sensors zur Messung der Ultraschallamplitude in einem Datenerfassungs- und Auswertegerät zu einer einzigen Größe verknüpft werden, welche den Bondvorgang charakterisiert und die Regelung der Bondmaschine ermöglicht.

Während der Herstellung von integrierten Schaltkreisen werden die Chips auf einen Trägerkörper aufgeklebt und mittels dünner Gold- oder Aluminiumdrähte an den Rahmen kontaktiert. Da für die Überwachung der halb- und vollautomatischen Bondmaschinen bisher keine zufriedenstellend arbeitenden Vorrichtungen zur Verfügung stehen, kommt es öfters im Laufe der Zeit zu mehr oder weniger gravierenden Einstellabweichungen der Bondmaschine, was eine Beeinträchtigung der Qualität der ausgeführten Bondverbindungen mit sich bringt.

Aus der US-A-38 27 619 ist eine gattungsgemäße Vorrichtung zur Überwachung der Bondkraft und der Ultraschallamplitude bekannt, bei welcher als erster Sensor zur Messung der Bondkraft ein unterhalb des jeweiligen Bausteins angeordneter piezoelektrischer Sensor und als zweiter Sensor zur Messung der Ultraschallamplitude eine an den Anschlußdraht des Ultraschallgenerators angekoppelte Spule vorgesehen sind. Die Ausgangssignale der beiden Sensoren beaufschlagen ein Datenerfassungs- und Auswertegerät, mit welchem die Qualität der Bondverbindungen überwacht wird. Eine ähnlich aufgebaute Vorrichtung, mit welcher die Bondkraft, die Schwingungsamplitude und der Weg des Bondarms gleichzeitig registriert werden, ist aus der DE-Z:DVS-Berichte, Bd. 40, Nov. 1976, S. 122-126 bekannt.

Aus der US-A-3 857 279 ist eine Vorrichtung zur Überwachung der Ultraschallamplitude während des Bondprozesses bekannt, bei welcher hierzu am Bondwerkzeug oder am Ultraschallgenerator ein piezoelektrischer Sensor angebracht wird. Diese bekannte Vorrichtung umfaßt auch Mittel zur frequenzmäßigen Zerlegung des verstärkten Ausgangssignals des piezoelektrischen Sensors in mehrere Anteile, die ganzzahligen Vielfachen der Grundfrequenz des Ultraschallgenerators entsprechen.

Aus der DE-A-34 35 511 ist es bekannt, an dem Schaft der Elektrode einer Widerstandpunktschweißmaschine vier um 90° versetzte und zur Elektrodenachse parallel ausgerichtete Dehnungsmeßstreifen anzubringen. Diese Dehnungsmeßstreifen sind mit einer Anzeige- bzw. Auswerteeinrichtung verbunden, so daß die Größe der Axialkraft, der Querkraft und der Absolutkraft berechnet werden kann sowie der Kraftangriffswinkel der Absolutkraft.

Weitere Einsatzmöglichkeiten von Dehnungsmeßstreifen zur Messung von Dehnungen mechanisch beanspruchter Bauteile sind aus Doeblin "Measurement Systems", Mc Graw Hill, 1983, Seiten 235, 236 bekannt.

Der Erfindung liegt die Aufgabe zugrunde, bei einer gattungsgemäßen Vorrichtung während des Bondvorganges die Bondparameter, Bondkraft und Ultraschallamplitude kontinuierlich mit solchen Mitteln zu messen und zu registrieren, daß unerwünschte Einstellabweichungen der Bondmaschinen vermieden werden und eine gleichbleibende Qualität der Bondverbindungen sichergestellt wird.

Die Lösung dieser Aufgabe erfolgt bei einer gattungsgemäßen Vorrichtung durch
- an der Ober- und Unterseite des Bondarms angebrachte, den ersten Sensor bildende Dehnungsmeßstreifen, die die vertikale Verbiegung des Bondarms, die der Bondkraft proportional ist, messen ;
- einen seitlich am Bondarm angebrachten, den zweiten Sensor bildenden piezoelektrischen Sensor;
- Mittel zur frequenzmäßigen Zerlegung des verstärkten Ausgangssignals des zweiten Sensors in mehrere Anteile, die ganzzahligen Vielfachen der Grundfrequenz des Ultraschallgenerators entsprechen, und durch
- einen ausgangsseitig an das Datenerfassungs- und Auswertegerät angeschlossenen Speicherbaustein, in welchem die momentanen Amplituden der einzelnen frequenzmäßig zerlegten und in eine Gleichspannung verwandelten Anteile zum Zeitpunkt des Bondens gespeichert sind.

Vorzugsweise ist als Speicherbaustein ein sample and hold-Baustein vorgesehen.

Gemäß einer vorteilhaften Weiterbildung der Erfindung ist dem Datenerfassungs- und Auswertegerät als zusätzlicher Bondparameter die Temperatur eines zu bedienenden Bausteins zugeführt.

Gemäß einer weiteren bevorzugten Ausgestaltung der Erfindung ist vorgesehen, daß in dem Datenerfassungs- und Auswertegerät ein Soll/Istwertvergleich durchgeführt wird zur Steuerung der Bondmaschine in Abhängigkeit dieses Vergleichs.

Der wesentliche Vorteil der Erfindung liegt darin begründet, daß damit der Verlauf der Bondkraft und der Ultraschallamplitude über den gesamten Bondprozeß hinweg gleichzeitig und kontinuierlich aufgenommen und analysiert werden kann. Aus den gemeinsamen Signalen (und gegebenenfalls der Meßgröße Temperatur des Bauteils) wird eine gemeinsame Größe erstellt, die in charakteristischer Weise über den Bondvorgang Aufschluß gibt, die Regelung der Bondmaschine ermöglicht und damit eine gleichbleibende Qualität der Bondverbindung sicherstellt.

Anschließend an das Auswertegerät wird der Verlauf der Bondkraft und des Ultraschalls zum Beispiel auf einen Schreiber oder Plotter ausgegeben. Solche Meßprotokolle dienen der Auswertung und können zur Verdeutlichung der Verläufe der Bondkraft und des Ultraschallsignals verwendet werden.

Die Erfindung wird anhand der Figuren erläutert. Es zeigen:

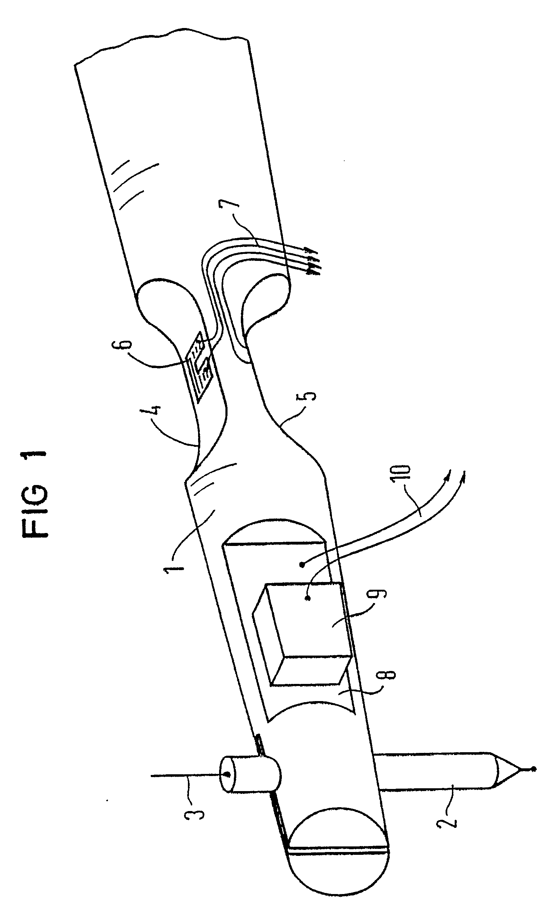

Figur 1 einen Bondarm mit Mitteln zur Überwachung der Bondparameter und
Figur 2 ein Blockschaltbild der Elektronik für diesen Vorgang.

Die Erfindung wird an einem Ausführungsbeispiel mit Dehnungsmeßstreifen als Kraftmeßeinrichtung beschrieben. Mit 1 ist ein Bondarm bezeichnet, durch dessen Bondspitze 2 ein Draht 3, zum Bei spiel aus Gold oder Aluminium, verläuft. An der Ober-und Unterseite 4, 5 des Bondarmes mit kreisförmigem Querschnitt sind Dehnungsmeßstreifen (DMS) angebracht, von denen in der Figur nur der obere 6 sichtbar ist. Diese Dehnungsmeßstreifen können auch in flachen Ausfräsungen an der Ober-und Unterseite angebracht sein. Von diesen DMS führen Verbindungsleitungen 7 zu einem nicht dargestellten Verstärker des Bondkraftsignals. In einer seitlichen Anfräsung 8 ist ein Sensor 9 angeordnet, der über Leitungen 10 mit einem nicht gezeichneten Verstärker für die Ultraschall-Signale verbunden ist. Bei einem Bondarm, der von Haus aus eine Flachstelle besitzt, kann die Notwendigkeit zur Ausfräsung entfallen.

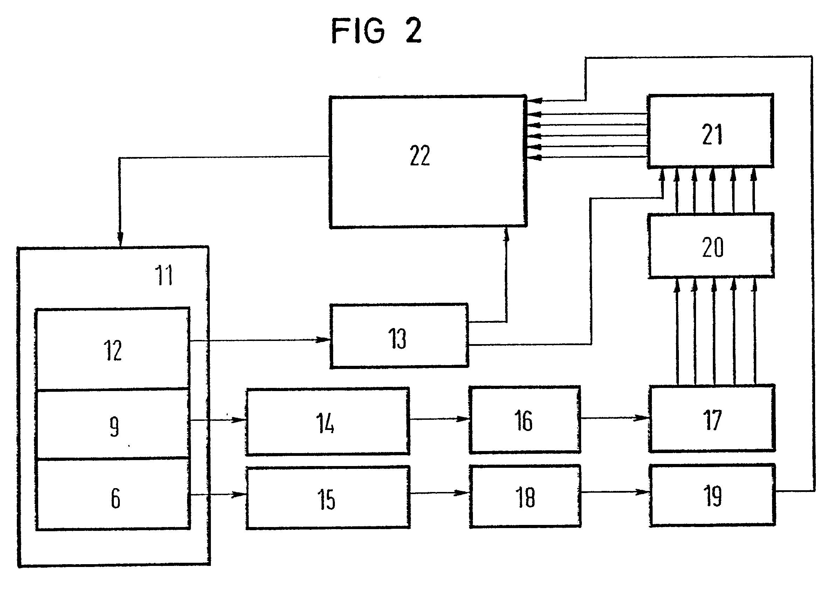

Nach der Darstellung in der Figur 2 umfaßt ein Bonder 11 unter anderem folgende Teile, die Signale abgeben: einen Ultraschallgenerator 12 an einen Trigger 13, einen Sensor am Bondarm 9 an einen Verstärker 14 und die DMS auf den Bondarm an einen Verstärker 15, zum Beispiel einen Operationsverstärker. Ausgangsseitig ist der Verstärker 14, der ebenfalls ein Operationsverstärker sein kann, mit einem 60 kHz Hochpaß 16 verbunden, dessen Ausgang zu einer Filterbank 17 führt. Die Filterbank besteht aus Durchlaßfiltern für die Oberschwingungen der Grundfrequenz des Ultraschallgenerators (60 kHz). Durch die fünf dargestellten Pfeile an der Ausgangsseite der Filterbank ist symbolisiert, daß beispielsweise die Frequenzen 60, 120, 180, 240 und 300 kHz zur Weiterverarbeitung gelangen. Zwischenwerte sind damit ausgeschlossen, aber die Auswertung weiterer Vielfacher der Grundfrequenz durchaus möglich.

Die Signale des Verstärkers 15 gelangen in ein Filter 18, an das sich ein Zwischenspeicher (latch) 19 anschließt. An den Ausgang eines AC/DC Umwandlers 20 ist ein sample and hold-Baustein 21 angeschlossen, dessen Werte in das Auswertegerät 22 kommen.

Der Bondparameter Bondkraft wird durch die auf dem Bondarm angebrachten DMS erfaßt. An diesen Stellen mißt der aufgekiebte DMS die vertikale Verbiegung des Bondarmes während des Bondvor ganges. Diese Größe ist der Bondkraft proportional, so daß ein geeigneter, nachgeschalteter Verstärker eine der Kraft proportionale Spannung abgibt. Diese Spannung wird über das Filter 18, zum Beispiel ein Tiefpaßfilter, und ein latch 19 dem Datenerfassungs-und Auswertegerät 22 zugeführt.

Die Messung und Überwachung des Parameters Ultraschall geschieht durch die Messung der Ultraschallamplitude am Bondarm selbst. Dazu wird der Bondarm seitlich flach angefräst und mit einem piezoelektrischen Sensor 9 bestückt. Dieser Sensor registriert während des Bondvorganges das Ultraschallsignal und führt es einem geeigneten Verstärker 14 zu. Nach dieser Verstärkerstufe wird das Signal in dem Hochpaß 16 frequenzmäßig in mehrere Anteile zerlegt. die ganzzahligen Vielfachen der Grundfrequenz von 60 kHz entsprechen (Frequenz des Ultraschall-Generators). Dadurch wird eine separate Messung der Grundfrequenz von 60 kHz und der Oberschwingungen ermöglicht. Da der Anteil der Oberschwingungen bedingt wird durch die Wechselwirkung des Bondarmes mit dem IC (über Bondspitze und Au-ball), kann durch diese Art der Messung, nämlich Grundfrequenz und Anteil der Oberschwingungen, diese Einflußgröße auf die Bondverbindung gemessen und kontinuierlich überwacht werden. Die einzelnen, frequenzmäßig zeriegten Anteile des Ultraschallsignales werden per Datenauswertegerät erfaßt und weiterverarbeitet. Dazu werden die Signale in eine Gleichspannung (Baustein 20) verwandelt und ihre momentane Amplitude zum Zeitpunkt des Bondens zum Beispiel mittels des sample/hold-Bausteines festgehalten.

Diese gemessenen Parameter, Bondkraft und Ultraschallamplitude, werden zu einem gegebenen Zeitpunkt (Triggerimpuls vom Ultraschallgenerator) zusammen mit anderen Größen (zum Beispiel Temperatur des Bausteins) ausgelesen und dem Auswertegerät 22 zugeführt. Dort werden die gemessenen Werte weiterverarbeitet, mit Richtwerten verglichen, wodurch die Möglichkeit der Beurteilung der durchgeführten Bondverbindung entsteht. Aus den gemessenen Parametern wird eine gemeinsame Größe erstellt, die den Bondvorgang charakterisiert. Ferner können die verschiedenen Bondparameter der Bondmaschine über diese Regelgröße den Bond vorgang der Bondmaschine regeln und somit den Ablauf konstant halten. Dadurch wird eine gleichbleibende Qualität der Bondverbindung sichergestellt.

## Patentansprüche

1. Vorrichtung zur kontinuierlichen Überwachung der Bondkraft und der Ultraschallamplitude bei halb- und vollautomatischen, einen Ultraschallgenerator und einen Bondarm (1) aufweisenden Bondmaschinen (11), bei welcher die verstärkten Ausgangssignale eines ersten Sensors (6) zur Messung der Bondkraft und eines zweiten Sensors (9) zur Messung der Ultraschallamplitude in einem Datenerfassungs- und Auswertegerät (22) zu einer einzigen Größe verknüpft werden, welche den Bondvorgang charakterisiert und die Regelung der Bondmaschine (11) ermöglicht,
**gekennzeichnet durch**
- an der Oberseite und Unterseite des Bondarms (1) angebrachte, den ersten Sensor (6) bildende Dehnungsmeßstreifen, die die vertikale Verbiegung des Bondarms (1), die der Bondkraft proportional ist, messen;
- einen seitlich am Bondarm (1) angebrachten, den zweiten Sensor (9) bildenden piezoelektrischen Sensor;
- Mittel zur frequenzmäßigen Zerlegung des verstärkten Ausgangssignals des zweiten Sensors (9) in mehrere Anteile, die ganzzahligen Vielfachen der Grundfrequenz des Ultraschallgenerators (12) entsprechen, und durch
- einen ausgangsseitig an das Datenerfassungs- und Auswertegerät (22) angeschlossenen Speicherbaustein (21), in welchem die momentanen Amplituden der einzelnen frequenzmäßig zerlegten und in eine Gleichspannung verwandelten Anteile zum Zeitpunkt des Bondens festgehalten sind.

2. Vorrichtung nach Anspruch 1, **dadurch gekennzeichnet,** daß als Speicherbaustein (21) ein sample and hold-Baustein vorgesehen ist.

3. Vorrichtung nach Anspruch 1 oder 2, **dadurch gekennzeichnet,** daß dem Datenerfassungs- und Auswertegerät (22) als zusätzlicher Bondparameter die Temperatur eines zu bondenden Bausteins zugeführt ist.

4. Vorrichtung nach einem der Ansprüche 1 bis 3, **dadurch gekennzeichnet,** daß in dem Datenerfassungs- und Auswertegerät (22) ein Soll/Istwertvergleich durchgeführt wird zur Steuerung der Bondmaschine (11) in Abhängigkeit dieses Vergleichs.

## Claims

1. Device for continually monitoring the bonding force and the ultrasonic amplitude in semi-automatic and fully automatic bonding machines (11) having an ultrasonic generator and a bonding arm (1), in which the amplified output signals of a first sensor (6) for measuring the bonding force and of a second sensor (9) for measuring the ultrasonic amplitude are logically combined in a data collecting and evaluating unit (22) to form a single variable which characterizes the bonding process and permits the control of the bonding machine (11), characterized by
- strain gauges, which are fitted to the topside and the bottom side of the bonding arm (1), form the first sensor (6) and measure the vertical warping of the bonding arm (1), which is proportional to the bonding force;
- a piezoelectric sensor which is fitted laterally to the bonding arm (1) and forms the second sensor (9);
- means for the resolution in terms of frequency of the amplified output signal of the second sensor (9) into a plurality of components which correspond to integral multiples of the fundamental frequency of the ultrasonic generator (12), and by
- a memory chip (21), which is connected on the output side to the data collecting and evaluating device (22), in which are stored the instantaneous amplitudes of the individual components which have been resolved in terms of frequency and transformed into a direct voltage, at the moment of bonding.

2. Device according to Claim 1, characterized in that a sample-and-hold chip is provided as the memory chip (21).

3. Device according to Claim 1 or 2, characterized in that the temperature of a chip to be bonded is fed as additional bonding parameter to the data collecting and evaluating device (22).

4. Device according to one of Claims 1 to 3, characterized in that a desired value/actual value comparison is carried out in the data collecting and evaluating device (22) for controlling the bonding machine (11) as a function of this comparison.

## Revendications

1. Dispositif pour contrôler en continu la force de liaison et l'amplitude des ultrasons dans des machines de liaison semi-automatiques et entièrement automatiques (11), comportant un générateur d'ultrasons et un bras (1) d'exécution de la liaison, et dans lequel les signaux de sortie amplifiés d'un premier capteur (6) servant à mesurer la force de liaison et d'un second capteur (9) servant à mesurer l'amplitude des ultrasons sont réunis dans un appareil de détection et d'évaluation de données (22) pour former une grandeur unique qui caractérise l'opération de liaison et permet le réglage de la machine de liaison (11),
caractérisé par
- des jauges extensométriques qui sont montées sur la face supérieure et sur la face inférieure du bras (1) d'établissement de la liaison et qui forment le premier capteur (6) et qui mesurent la flexion verticale du bras (1) d'établissement de la liaison, qui est proportionnelle à la force de liaison;
- un capteur piézoélectrique monté latéralement sur le bras (1) d'établissement de la liaison et formant le second capteur (9);
- des moyens pour diviser en fréquence le signal de sortie amplifié du second capteur (9) en plusieurs composantes, qui correspondent à des multiples entiers de la fréquence de base du générateur d'ultrasons (12), et
- un module de mémoire (21) raccordé côté sortie à l'appareil de détection et d'évaluation de données (22), et dans lequel les amplitudes instantanées des différentes composantes, séparées du point de vue des fréquences et converties en une tension continue, sont maintenues fermement à l'instant de l'établissement de la liaison.

2. Dispositif suivant la revendication 1, caractérisé par le fait qu'il est prévu, comme module de mémoire (21), un module d'échantillonnage et de blocage sample and hold.

3. Dispositif suivant la revendication 1 ou 2, caractérisé par le fait que la température d'un module devant être réuni est appliquée, en tant que paramètre supplémentaire de liaison, à l'appareil de détection et d'évaluation de données (22).

4. Dispositif suivant l'une des revendications 1 à 3, caractérisé par le fait qu'une comparaison valeur de consigne/valeur réelle est exécutée dans l'appareil de détection et d'évaluation de données (22), pour la commande de la machine de liaison (11) en fonction de cette comparaison.
